Europäisches Patentamt

European Patent Office

Office européen des brevets

(11) Publication number: **0 065 277**
**B1**

# EUROPEAN PATENT SPECIFICATION

(45) Date of publication of patent specification: **08.01.86**

(51) Int. Cl.⁴: **H 01 L 21/203, H 01 J 37/00**

(21) Application number: **82104146.4**

(22) Date of filing: **12.05.82**

(54) **High speed dry etching method.**

(30) Priority: **20.05.81 JP 74843/81**

(43) Date of publication of application:
**24.11.82 Bulletin 82/47**

(45) Publication of the grant of the patent:
**08.01.86 Bulletin 86/02**

(84) Designated Contracting States:
**DE FR GB NL**

(56) References cited:
**EP-A-0 014 819**
**EP-A-0 017 143**
**WO-A-80/01623**
**DD-A- 145 348**
**DE-A-2 340 442**
**US-A-3 669 774**
**US-A-4 127 437**

(73) Proprietor: **Kabushiki Kaisha Toshiba
72, Horikawa-cho Saiwai-ku
Kawasaki-shi Kanagawa-ken 210 (JP)**

(72) Inventor: **Okano, Haruo
B 142, Ookurayama-Daini-Corporus
925-1, Mamedo-cho Kohoku-ku (JP)**
Inventor: **Horiike, Yasuhiro
895-17, Ko, Tateno-machi
Nerima-ku Tokyo (JP)**

(74) Representative: **Henkel, Feiler, Hänzel & Partner
Möhlstrasse 37
D-8000 München 80 (DE)**

Courier Press, Leamington Spa, England.

## Description

This invention relates to a method of dry etching the surface of a sample as defined in the precharacterizing part of the claim 1. Such dry etching is for use in the manufacture of electrical parts such as semiconductor integrated circuits.

The miniaturization of integrated circuits has made such rapid progress in the last few years that recently very large scale integrated circuits (VLSI's) have been developed with dimensions of 1—2 µm. For such miniaturization, a method that has attracted attention is the Reactive Ion Etching method (RIE), wherein a reactive gas, such as $CF_4$ or $CCl_4$, is introduced into a vacuum vessel having parallel-plate type electrodes; glow discharge is produced by applying high frequency electric power to the electrodes on one of which the sample to be etched has been placed, and etching is effected by accelerating the positive ions in the plasma by means of the negative DC self-bias (cathode voltage drop) produced at this electrode, irradiating the sample vertically.

In this RIE method, however, when etching $SiO_2$ using $CF_4 + H_2$ gas, for example, the etching rate was at most 30.0—40.0 nm/min, which meant that it took twenty to thirty minutes to etch a 1 µm $SiO_2$ film. Etching speed was also slow in the case of Al and poly-Si, and the method is ill-adapted for mass production. It is known that increasing the operating current is effective, but this brings with it the danger of an increase in the cathode voltage drop, with the risk of ion damage and a decrease in the etching selectivity ratio. Another limitation was that the resist used to mask the surface reached a high temperature and became subject to deformation.

The present inventors previously developed a high-speed RIE method for etching monocrystal-line Si, $SiO_2$, Al, Mo, W and poly-Si without any risk of ion damage. In this method a magnetron discharge is used for etching by applying a magnetic field perpendicular to an electric field between the parallel electrodes within a reaction chamber where a reactive gas, $CF_4$ mixed with $H_2$, is introduced for ionization. According to the parent application, when a sample is to be etched, a sample pellet made of a nonmagnetic material, for example, carbon or alumina, is placed on a pole piece. The sample is placed on the sample pallet. The inside of the reaction chamber is evacuated by opening a vacuum sealing valve, and an etchant gas is supplied from a gas inlet port. High frequency power is supplied to the cathode. By this power, glow discharge is generated between the electrodes so that a plasma is produced from the etchant gas. A cathode voltage drop (negative current self bias) is induced at the cathode. In this condition, in the vicinity of the discharge gap, a magnetic flux perpendicular to the electric field is induced. Therefore, electrons in the vicinity of the field drift in the direction $E \times B$ so that the electrons are trapped in a helical drift track in the vicinity of the discharge gap. The ionizing efficiency of the etchant gas in the vicinity above the discharge gap greatly increases in comparison with the surrounding space. As a result, in comparison with the conventional DC self bias voltage, the present invention requires low power for high plasma density. This principle of operation is the basis of high speed etching. This method enables etching to be done at high rates such as more than 6.00 nm/min for $SiO_2$. The method, however, has a shortcoming in that the etching selectivity ratio of $SiO_2/Si$ (the ratio of the etching rate of $SiO_2$ to that of Si) is so low that detection of the end point of etching is difficult when etching, for example, an $SiO_2$ layer on a Si substrate. Another problem is that in some areas on the surface of the sample to be etched a glow discharge condition arises, which results in accumulation of a polymer film on the surface.

Document WO 80/01623 discloses a method in which $CHF_3$ gas is used as a reactive gas. However, a glow discharge is provided, with the result that it is impossible to obtain a high etching selectivity ratio, e.g. SiO/Si ratio. Furthermore, the earlier published EP—A—0017143 teaches a microwave plasma etching apparatus in which sample is transported revolving along a circular orbit in a plasma exposure region, and resonance is brought about by the magnetic field.

The earlier published EP—A—0014819 discloses a sputtering cathode and a system for sputter coating relatively large area architectural substrates, in which the movement of ions is modified by means of a magnetic field.

The use of hydrogen as a carrier gas in a dry etching process wherein the reactive gas has a molecule comprising atoms of hydrogen and fluorine is known from document US—A—3 669 774.

It is therefore an object of the invention to provide an improved method of high-speed dry etching for use in the manufacture of products such as semiconductor devices.

It is a specific object of the invention to provide an improved method of high-speed dry etching having a high etching selectivity ratio of $SiO_2/Si$ for use in the manufacture of semiconductor devices such as integrated circuits.

It is another specific object of the invention to provide an improved method of high-speed dry etching without polymer accumulation on the surface of the material to be etched.

In order to solve these objects, the invention provides a method as defined in the claim 1.

Thus according to the present invention a method of high-speed dry etching is provided in which a reactive gas, such as $CHF_3$, whose molecules contain atoms of at least fluorine (F) and hydrogen (H), is introduced into a d⋯ompression vessel. A magnetron discharge is generated in the area between parallel electrodes in the vessel by applying to the electrodes an electric field and a magnetic field which are perpendicular to each other, thereby ionizing the reactive gas through the reaction between electrons in drift motion and the gas molecules. The sample to be etched is then subjected to the reactive ions thus generated.

This invention can be more fully understood from the following detailed description when taken in conjunction with the accompanying drawings, in which:

Fig. 1 is a perspective view showing an apparatus for dry etching used in an embodiment of this invention;

Fig. 2 is a schematic diagram of the apparatus shown in Fig. 1;

Fig. 3 is a perspective view of a magnet used in the apparatus shown in Fig. 2;

Fig. 4 is a graph showing etching characteristics of silicon dioxide ($SiO_2$) in the method according to the present invention (Sccm represents $cm^3/$min as standardized at room temperature);

Fig. 5 is a graph showing etching characteristics of silicon dioxide ($SiO_2$) in the conventional method using $CF_4$ gas mixed with $H_2$ gas for comparison with the method of the present invention;

Fig. 6 is a plan view showing another example of a magnet assembly which may be used in the method according to the present invention; and

Fig. 7 is a sectional view taken on the line 7—7 of Fig. 6.

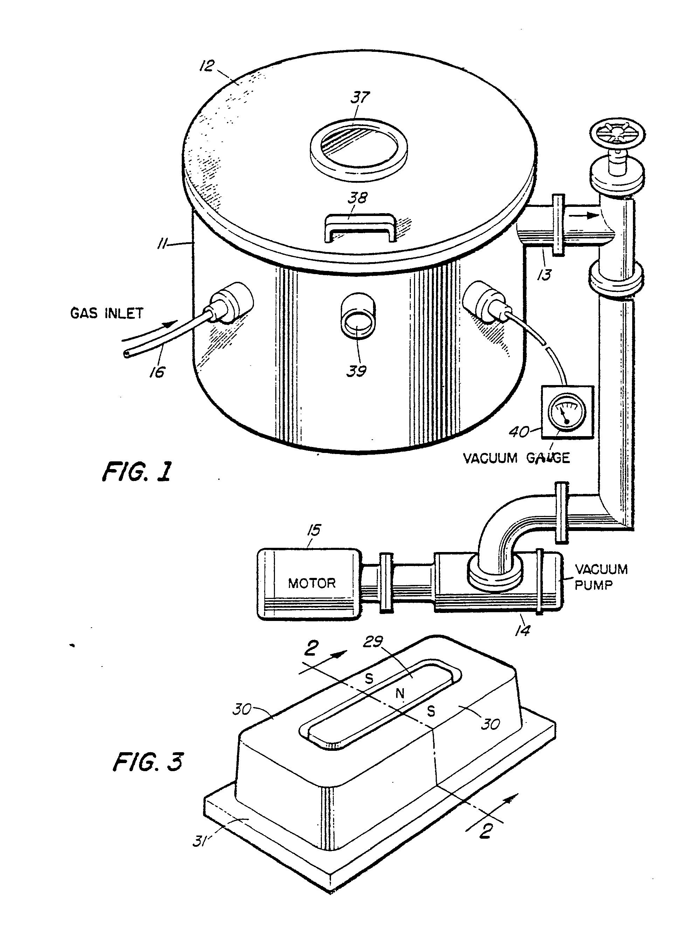

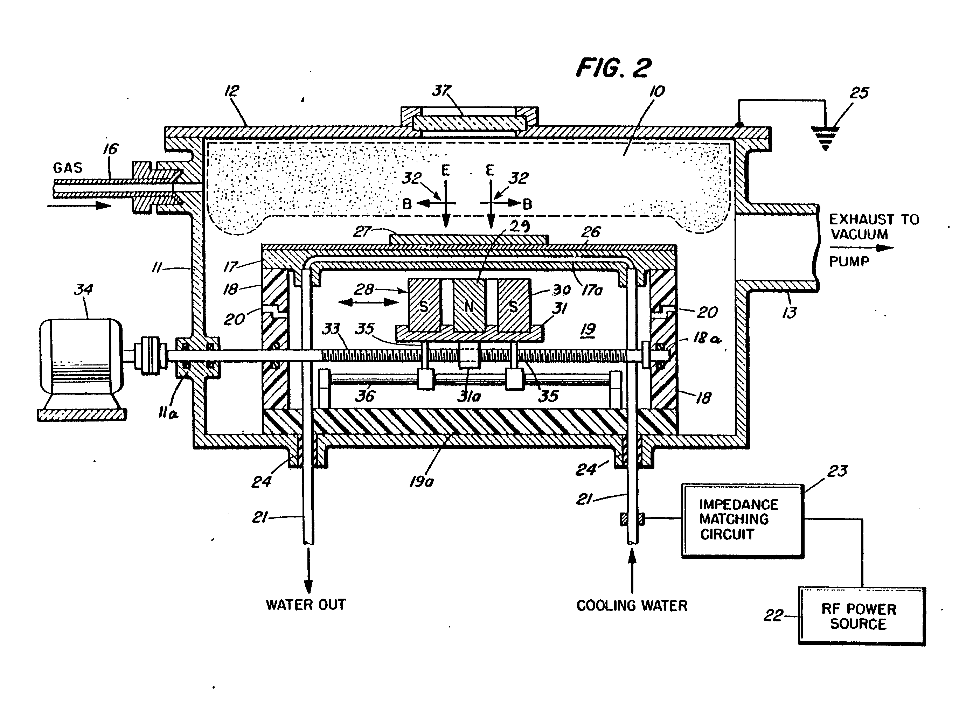

Figs. 1 and 2 show an apparatus used in the preferred embodiment of the method according to the present invention. A decompression vessel 11, made of stainless steel, is provided having a cover plate 12, also made of stainless steel, which seals an opening in the vessel 11. The vessel 11 has an exhaust outlet 13 in a side wall connected to an exhaust system including an exhaust pump 14 (such as diffusion pump), and a driving motor 15. The vessel 11 also has a gas inlet 16 in a side wall connected to a gas supply (not shown).

Within the vessel 11, a cathode plate 17, made of copper, is provided in parallel relationship with the cover plate 12 of the vessel 11. This cathode plate 17 is supported by a shield wall 18, made of an insulating material such as teflon, forming a shield room 19 having a bottom wall 19a fixed on the bottom of the decompression vessel 11. The shield room 19 is provided with several holes 20 in the shield wall 18 for communicating with the rest of the decompression vessel 11. Electrically conductive pipes 21 are provided for supplying cooling fluid, such as water, through a conduit network passageway flowpass 17a formed in the cathode plate 17 and for applying thereto a high frequency voltage from an RF power source 22 through an impedance matching circuit 23. The pipes 21 are connected at one end to the cathode plate 17 and at the other end to the matching circuit 23 and a fluid supply source (not shown) outside the decompression vessel 11. The pipes 21 are insulated by an insulator 24 from the bottom of the vessel 11. The cover plate 12 is electrically connected to ground 25 and forms the anode. On the cathode plate 17 there is provided a non-magnetized carbon plate 26 on which a sample 27 to be etched is mounted.

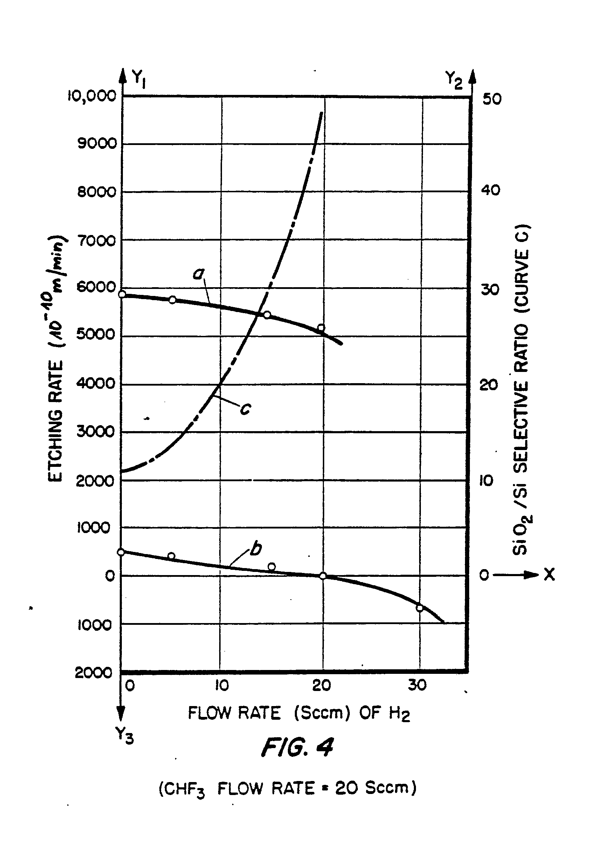

A magnet assembly 28 is installed under the cathode plate 17 in the shield room 19 which prevents the electric discharge from entering. The assembly 28 comprises, as shown in Fig. 3, first and second samarium-cobalt (Sm-Co) permanent magnets 29 and 30 each having a rectangular cross section, one of which (29) is surrounded by the other one (30). The first and second magnets 29 and 30 are mounted on a ferromagnetic substrate 31 such as soft iron which forms part of a magnetic circuit between the first and second permanent magnets. Fig. 2 includes a cross sectional view of these magnets taken along line I—I of Fig. 3. As shown in Fig. 2, the magnetic flux B flowing from the north pole of the first magnet 29 into the surrounding south pole of the second magnet 30 is parallel to the anode plate 12 and the cathode plate 17, within the area between the plates. This magnetic flux B corresponds to the air gap between the first magnet 29 and the second magnet 30. The substrate 31 supporting the magnets 29 and 30 is coupled to a rotating screw rod 33 by a nut 31a fixed on the lower side of the substrate 31. The rod 33 is rotatably received by journals 18a in the shield walls 18 and a journal 11a in the side wall of vessel 11. The screw rod 33 is driven by a motor 34 which alternately rotates the rod 33 clockwise and counterclockwise so that the magnets 29 and 30 move back and forth along the horizontal screw rod 33. The substrate 31 supporting the magnets 29 and 30 are supported by arms 35 guided along the horizontal guide rod 36 fixed on the bottom wall 19a of the shield room 19. In Fig. 1, 37 is a window in the cover 12 of the vessel 11 and 38 is a handle on the cover. There are also provided in the side wall of the vessel another window 39 and a vacuum gauge 40 for measuring the pressure in the decompression vessel 11.

The etching process is carried out using this apparatus as follows. The decompression chamber 11 is exhausted to less than 0.013332 Pa ($10^{-4}$ Torr) by means of the exhaust mechanism comprising exhaust outlet 13, exhaust pump 14 and motor 15. The shield room 19 enclosing the magnet assembly 28 is also evacuated through the air holes 20 in the side wall 18. When a pressure of less than 0.013332 Pa ($10^{-4}$ Torr) has been reached, a reactive halogen gas such as $CHF_3$, which has been mixed with $H_2$ gas, is introduced from the gas inlet 16 so that the pressure is controlled to a level of 0.013332 Pa to 1.3332 Pa ($10^{-4}$ to $10^{-2}$ Torr). When high-frequency power (13.56 MHz and about 1.6 $W/cm^2$ power density, for example) is applied from the RF power source 22 to the cathode plate 17, a glow discharge is generated in the area 10 between the electrodes 12 and 17. At the same time, a magnetron discharge is produced in the area 32 above the cathode plate 17 by the orthogonally intersecting electric and magnetic fields E × B. More specifically, because of the crossing electric field and magnetic flux, the former, E, due to the self-bias voltage and the latter, B, due to the magnets 29 and 30, free electrons in the neighborhood of the magnets begin to move in cycloidal paths and collide with molecules of the introduced reaction gas resulting in a high efficiency of ionization of the gas. This ionization efficiency is about 10—30 % which is ten times as high as the efficiency in a conventional glow discharge.

Since the magnetron discharge is generated only in the limited area 32 along the air gap between the first and second magnets, 29 and 30, the magnet assembly 28 is moved to scan the surface of the cathode plate 17. A uniform magnetron discharge is thus generated over the sample 27 mounted on the cathode plate 17. The ionized reactive gas thus generated by the plasma discharge contacts the sample 27 on the cathode plate 17 and performs high-speed etching.

Fig. 4 shows the result of etching of silicon (Si) and silicon dioxide ($SiO_2$) when $CHF_3$ is used, with $H_2$ added, as the introduced gas. The sample 27 was a wafer of Si on which an $SiO_2$ film was formed. The amount of high frequency electric power from the source 22 was 300 W, the $CHF_3$ flow rate 20 Sccm, and the etching pressure 0.01 Torr. The horizontal axis X of Fig. 4 represents the flow rate (in Sccm) of $H_2$ gas and the vertical axes $Y_1$—$Y_3$ represent etching rate ($10^{-10}$ m/min), etching selectivity ratio of $SiO_2$/Si, and polymer accumulation rate respectively. Curves (a) and (b) represent the etching rate of $SiO_2$ and Si respectively, and curve (c) represents the selectivity ratio of $SiO_2$/Si. For experimental purposes, these values were measured with the magnet assembly 28 stationary. As the graph shows, the $SiO_2$ etch rate (a) was as high as about 5,800 $10^{-10}$ m/min when $H_2$ gas was not added but the Si etching rate (b) was also as high as about 500 $10^{-10}$ m/min and the $SiO_2$/Si selectivity ratio was as low as about 12. $SiO_2$ etching rate (a) slowly decreased as $H_2$ was added and since the Si etching rate (b) was relatively low and decreased more slowly than the $SiO_2$ selectivity etching, the $SiO_2$/Si selectivity ratio (c) increased very rapidly. For example, the Si etching rate fell to about $10^{-9}$ m/min at an $H_2$ flow rate of 20 Sccm, and a very high value of over 40 was obtained for the selectivity ratio (c).

The Si etching rate (b) continued decreasing below zero when $H_2$ was added at flow rate over 20 Sccm. This means that a polymer film accumulated on the surface of the Si wafer instead of Si being etched away. In the preferred embodiment, therefore, the $H_2$ flow rate should be less than 20 Sccm to etch the wafer.

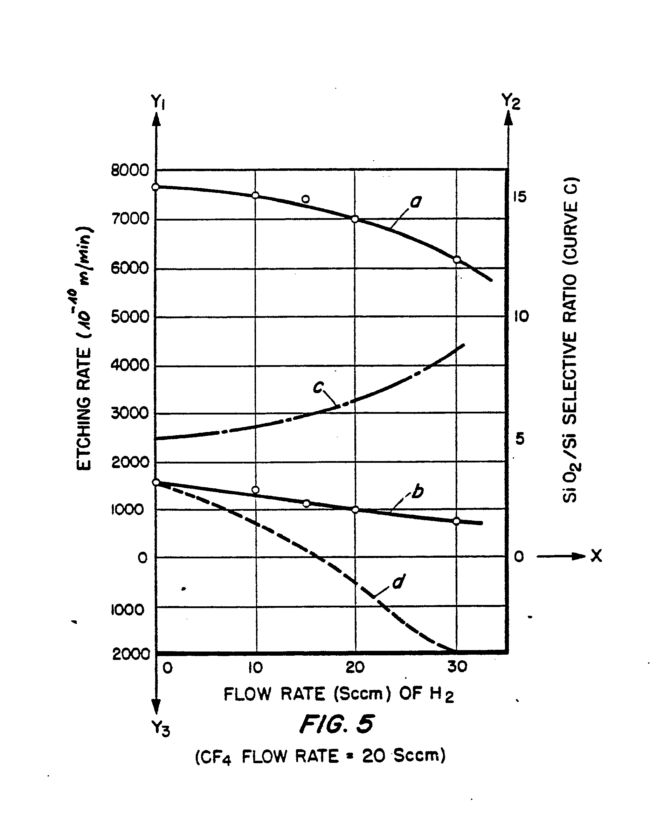

Fig. 5 shows the result of etching of Si and $SiO_2$ when $CF_4$ was used, with $H_2$ added, as the introduced gas in accordance with our previous invention, for the purpose of comparison with the etching characteristics in the present invention. The axes X, $Y_1$ to $Y_3$ and curves (a) to (c) correspond to those in Fig. 4. The $CF_4$ flow rate was also 20 Sccm; and other conditions such as the etching pressure and power of the RF source were the same as those in Fig. 4. As the graph shows, the $SiO_2$ etching rate (a) decreased from about 7,500 Å/min as $H_2$ was added, and since the Si etching rate (b) also decreased, the $SiO_2$/Si selectivity ratio (c) increased very slowly. For example, the selectivity ratio is below 10 at an $H_2$ flow rate of 30 Sccm, and even Si was etched to the extent of 7—8·$10^{-8}$ m. This necessitates an accurate and highly reliable method of detection of the end point of etching. On the contrary, the method according to the present invention, using a gas whose molecules contain atoms of at least F and H, makes it easier to detect the end point of etching since the Si etching rate (b) in Fig. 4 is much lower than that in Fig. 5 and the $SiO_2$/Si selectivity ratio (c) in Fig. 4 is much higher than that in Fig. 5. This is advantageous when etching $SiO_2$ with a Si mask over the $SiO_2$ and when carrying out high-speed and accurate etching. In particular, time is gained for detection of the etching end point when selectively removing a $SiO_2$ film laminated on to a Si wafer, using a resist pattern as a mask.

In Fig. 5, curve (d) shows the etching rate of Si in the regions other than the gaps between the first and second magnets 29 and 30 where the magnetic flux density B (orthogonally crossing the electric field E) is relatively low. In this region a glow discharge occurred instead of magnetron discharge. Curve (d), together with curves (a) through (c), was measured when the magnet assembly 28 was stopped, in order to clarify the phenomena occurring in the discharge areas. It is understood from curve (d) that the Si etching rate was different from area to area on the surface of the wafer, and a polymer film accumulated on the surface when the $H_2$ gas flow rate exceeded about 16 Sccm. From this experimental comparison it is clear that another advantage of the present invention is that polymer accumulation on the surface of the sample is avoided, thereby retaining a high etching rate and high selectivity ratio of the sample to be etched.

It should be noted that the scanning of the magnet assembly is useful to obtain a uniform and high quality etching since the magnetron discharge area is concentrated in the gap region of the magnets.

The reason why the method according to the present invention is superior to the former method in the selectivity ratio of $SiO_2$/Si and polymer accumulation is not certain. It is, however, supposed from the experiments that the reactive gas whose molecules contain fluorine (F) and hydrogen (H) effectively controls the etching speed of Si. More specifically, in the former magnetron discharge method using $CF_3$ gas there was a very high gas dissociation efficiency, with the result that a large quantity of F radicals are produced by dissociation of $CF_4$ gas, and these act as an etching starter for Si. Thus the F radicals have to be removed from the system. This was achieved by converting them to HF by mixing with a large quantity of $H_2$ A high $H_2$ flow rate, however, decreased the $SiO_2$ etching rate and, thus, high-speed etching could not be achieved. In the method according to the present invention, on the contrary, generation of the F radicals is controlled by the H contained in the reactive gas itself, as well as by the $H_2$ gas added. It seems that the magnetron discharge of the present invention generates almost the same amount of F radicals as those generated in the conventional glow discharge.

It should be noted that there will be various modifications within the scope of the invention.

The preferred embodiment described above has dealt with the case of a $SiO_2$ film as a sample to be etched; however, a silicon oxide film including phosphorous (P) or boron (B) may be etched using this method, as may be a film of silicon nitride. Again, the results described above are not limited to single-crystal silicon in the Si wafer, but can be achieved also with poly-crystalline or amorphous silicon.

Although $CHF_3$ gas was mentioned above, the invention is not restricted to the use of this gas. Any gases whose molecules contain at least hydrogen atom and fluoride atom, such as HF, gas can be used. Again, $H_2$ gas was used to reduce the amount of F radicals, but hydrocarbon gases, such as $C_2H_4$, can be used instead of the $H_2$ gas.

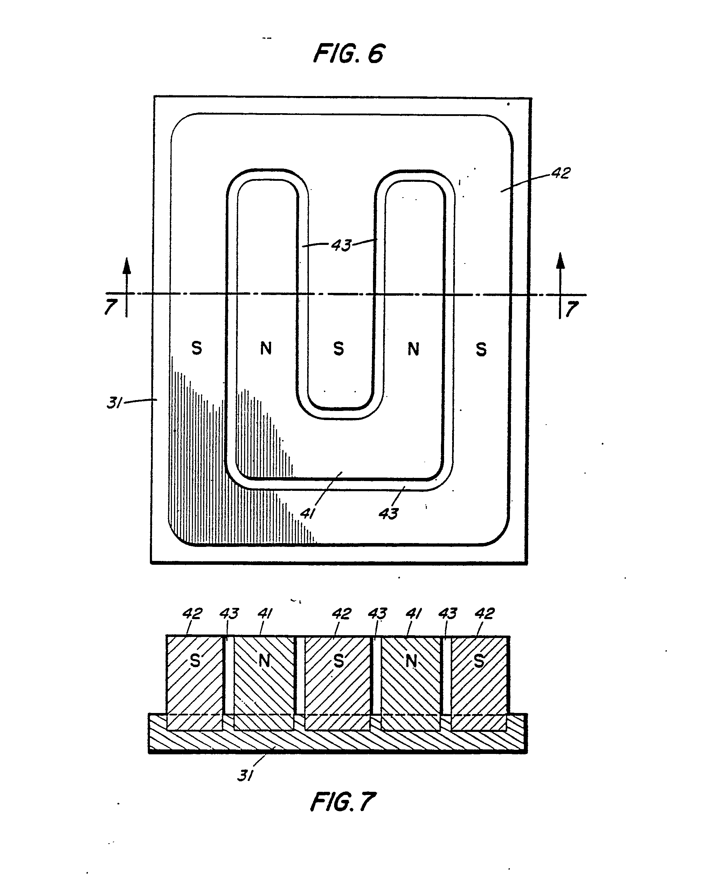

The magnet assembly with first and second magnets can be replaced by magnets having more complicated configurations as shown in Figs. 6 and 7. A first magnet 41 is bent into a U-shaped and the second magnet 42 is interdigitally engaged with the first magnet 41. This type of magnet assembly provides longer gap region 43 for the magnetron discharge.

Although illustrative embodiments of the present invention have been described in detail with reference to the accompanying drawings, it is to be understood that the invention is not limited to those precise embodiments and that various changes or modifications may be effected therein by one skilled in the art without departing from the scope of the invention.

## Claims

1. A method of dry etching the surface of a sample in a decompression vessel including a pair of spaced electrodes and introduced with a reactive gas wherein ions of the reactive gas are irradiated on the sample to effect the etching, comprising the steps of:

introducing into the vessel a reactive gas having molecules comprising atoms of fluorine and hydrogen;

generating between the spaced electrodes an electric field by applying a high frequency voltage to the electrodes;

generating a discharge within the vessel to ionize the reactive gas; and

exposing the surface of the sample to the ionized gas characterized in that

said vessel (11) includes also a magnetic assembly (28) to create a magnetic field in a limited area adjacent to one of the electrodes (12, 17),

a scavenging gas is introduced prior to generating the discharge into the vessel (11) to scavenge the fluorine,

said electric field is orthogonal to the magnetic field,

said discharge is a magnetron discharge produced by said electric and magnetic fields in the vicinity of the sample (27), and

the magnetic field is moved to generate a uniform magnetron discharge over the sample.

2. The method of claim 1, characterized in that the reactive gas is $CHF_3$.

3. The method of claim 2, wherein the scavenging gas is $H_2$ gas.

4. The method of claim 1, characterized in that the magnetic assembly (28) is reciprocally moved along the surface of the electrode (17).

5. The method of claim 1, 2 or 3, characterized in that the sample (27) is a silicon wafer having a surface of which a silicon dioxide film is formed.

6. The method of claim 1, characterized in that the magnetic assembly (28) includes at least first and second permanent magnets (29, 30) mounted on a ferromagnetic substrate (31) forming a magnetic circuit having an air gap between said first and second magnets.

7. The method of claim 6, characterized in that each of said first and second permanent magnets has a rectangular cross section, and the first magnet is surrounded by the second magnet.

## Patentansprüche

1. Verfahren zum Trockenätzen der Oberfläche eines Prüflings (Werkstücks) in einem Dekompressionsgefäß, das zwei beabstandete Elektroden enthält und in das ein reaktives Gas eingeführt ist, wobei der Prüfling zur Durchführung des Ätzens mit Ionen des reaktiven Gases beaufschlagt wird, umfassend die folgenden Schritte:

Einführen eines reaktiven Gases mit Molekülen aus Fluor- und Wasserstoffatomen in das Gefäß,

zwischen den beabstandeten Elektroden erfolgende Erzeugung eines elektrischen Felds durch Anlegung einer Hochfrequenzspannung an die Elektroden,

Erzeugung einer Entladung im Gefäß zwecks Ionisierung des reaktiven Gases und

Beaufschlagung der Oberfläche des Prüflings mit dem ionisierten Gas, dadurch gekennzeichnet, daß

das Gefäß (11) auch eine Magnetanordnung (28) zur Erzeugung eines Magnetfelds in einem begrenzten Bereich nahe einer der Elektroden (12, 17) aufweist,

vor der Entladungserzeugung ein Spülgas zum Ausspülen des Fluors in das Gefäß (11) eingeführt wird,

das elektrische Feld orthogonal zum Magnetfeld liegt,

die Entladung eine durch das elektrische Feld und das Magnetfeld in der Nähe des Prüflings (27) erzeugte Magnetronentladung ist und

das Magnetfeld bewegt oder verschoben wird, um eine gleichmäßige Magnetronentladung über dem Prüfling (Werkstück) hervorzubringen.

2. Verfahren nach Anspruch 1, dadurch gekennzeichnet, daß das reaktive Gas $CHF_3$ ist.

3. Verfahren nach Anspruch 2, dadurch gekennzeichnet, daß das Spülgas gasförmiger $H_2$ ist.

4. Verfahren nach Anspruch 1, dadurch gekennzeichnet, daß die Magnetanordnung (28) hin- und hergehend längs der Oberfläche der Elektrode (17) bewegt wird.

5. Verfahren nach Anspruch 1, 2 oder 3, dadurch gekennzeichnet, daß der Prüfling (das Werkstück) (27) ein Siliziumplättchen mit einer Oberfläche ist, auf oder aus der eine Siliziumdioxidschicht erzeugt ist bzw. wird.

6. Verfahren nach Anspruch 1, dadurch gekennzeichnet, daß die Magnetanordnung (28) mindestens erste und zweite Dauermagnete (29, 30) aufweist, die auf einem ferromagnetischen Träger (31) zur Bildung eines Magnetkreises mit einem Luftspalt zwischen ersten und zweiten Magneten montiert sind.

7. Verfahren nach Anspruch 6, dadurch gekennzeichnet, daß jeder erste und zweite Dauermagnet einen rechteckigen Querschnitt besitzt und der erste Magnet vom zweiten Magneten umschlossen ist.

**Revendications**

1. Procédé d'attaque à sec de la surface d'un échantillon dans un vase de décompression incluant une paire d'électrodes espacées et introduites avec un gaz réactif, dans lequel les ions du gaz réactif sont propagés sur l'échantillon pour exécuter l'attaque, consistant à:

introduire dans le vase un gaz réactif comportant des molécules comprenant des atomes de fluor et d'hydrogène;

engendrer entre les électrodes espacées un champ électrique en appliquant une tension en radiofréquence aux électrodes;

engendrer une décharge à l'intérieur du vase pour ioniser le gaz réactif; et

exposer la surface de l'échantillon au gaz ionisé; caractérisé en ce que:

le vase (11) comprend également un ensemble d'aimants (28) pour créer un champ magnétique dans une zone limitée au voisinage d'une des électrodes (12, 17);

un gaz d'évacuation est introduit avant d'engendrer la décharge dans le vase (11) pour évacuer le fluor;

le champ électrique est orthogonal au champ magnétique;

la décharge est une décharge de magnétron produite sur les champs électrique et magnétique au voisinage de l'échantillon (27),

et en ce que le champ magnétique est déplacé pour engendrer une décharge de magnétron uniforme au-dessus de l'échantillon.

2. Procédé selon la revendication 1, caractérisé en ce que le gaz réactif est $CHF_3$.

3. Procédé selon la revendication 2, caractérisé en ce que le gaz d'évacuation est un gaz de $H_2$.

4. Procédé selon la revendication 1, caractérisé en ce que l'ensemble d'aimants (28) est déplacé alternativement le long de la surface de l'électrode (17).

5. Procédé selon l'une quelconque des revendications 1 à 3, caractérisé en ce que l'échantillon (27) est une tranche de silicium comportant une surface sur laquelle est formée une couche de dioxyde de silicium.

6. Procédé selon la revendication 1, caractérisé en ce que l'ensemble d'aimants (28) comprend au moins des premier et second aimants permanents (29, 30) montés sur un substrat ferromagnétique (31) constituant un circuit magnétique avec un intervalle d'air entre les premier et second aimants.

7. Procédé selon la revendication 6, caractérisé en ce que chacun des premier et second aimants permanents a une section transversale rectangulaire, et en ce que le premier aimant est entouré par le second aimant.

GAS INLET

*FIG. 1*

VACUUM GAUGE

MOTOR

VACUUM PUMP

*FIG. 3*

FIG. 2

FIG. 4

(CHF₃ FLOW RATE = 20 Sccm)

*FIG. 5*

(CF₄ FLOW RATE = 20 Sccm)

**FIG. 6**

**FIG. 7**

5